# EUROPÄISCHE PATENTSCHRIFT

(11) **EP 1 683 200 B1**
(45) Veröffentlichungstag und Bekanntmachung des Hinweises auf die Patenterteilung: **13.02.2008**
(21) Anmeldenummer: 04791285.2
(22) Anmeldetag: 22.10.2004
(51) Int. Cl.: H01L 27/11

(54) **SPEICHERTRANSISTOR UND SPEICHEREINHEIT MIT ASYMMETRISCHEM TASCHENDOTIERBEREICH**
MEMORY TRANSISTOR AND MEMORY ELEMENT WITH AN ASYMMETRICAL POCKET DOPING REGION
TRANSISTOR DE MEMOIRE ET UNITE DE MEMOIRE A ZONE EN POCHE DOPEE ASYMETRIQUE

(30) Priorität: 12.11.2003 DE 10352785
(43) Veröffentlichungstag der Anmeldung: 26.07.2006
(73) Patentinhaber: Infineon Technologies AG, 81669 München (DE)
(72) Erfinder: GEISSLER, Christian, 93051 Regensburg (DE); SCHULER, Franz, 01109 Dresden (DE); SHUM, Danny Pak-Chum, Poughkeepsie, NY 12601 (US)
(74) Vertreter: Kindermann, Peter
(86) Internationale Anmeldenummer: PCT/EP2004/052623
(87) Internationale Veröffentlichungsnummer: WO 2005/048349

(56) Entgegenhaltungen:
- US-A- 5 912 488
- US-A1- 2003 133 353
- US-B1- 6 518 122
- OHSHIMA Y ET AL: "Process and device technologies for 16 Mbit EPROMs with large-tilt-angle implanted p-pocket cell" IEEE, 9. Dezember 1990 (1990-12-09), Seiten 95-98, XP010554686

## Beschreibung

Die Erfindung betrifft einen integrierten Speichertransistor, der bspw. in einem Halbleitersubstrat ausgebildet wird, mit:
- zwei Anschlussbereichen, die üblicherweise mit einem Dotiertyp dotiert sind der vom Dotiertyp eines Kanalbereiches abweicht und als Source- bzw. Drainbereich bezeichnet werden. Gegebenenfalls enthalten die Anschlussbereiche auch Erweiterungen, sogenannte Extensions, die geringer dotiert sind als die Anschlussbereiche.
- einem zwischen den Anschlussbereichen angeordneten Kanalbereich, der üblicherweise gemäß einer Substratgrunddotierung oder gemäß einer sogenannten Wannendotierung leicht dotiert ist und der zur Ausbildung eines Inversionskanals zwischen den Anschlussbereichen dient,
- einem Steuerbereich, der üblicherweise elektrisch leitfähig ist und als Gate bezeichnet wird,
- einem zwischen dem Steuerbereich und dem Kanalbereich angeordneten Ladungsspeicherbereich, der aus einem elektrisch leitenden oder aus einem elektrisch isolierendem Material besteht und als Floating Gate bezeichnet wird,
- einem Taschendotierbereich mit einem gleichen Dotiertyp wie der Kanalbereich aber mit einer anderen Dotierstoffkonzentration als im Kanalbereich.

Solche Speichertransistoren werden bspw. in FLASH-EEPROM (Electrical Erasable Programable Read Only Memory) eingesetzt, wobei es sich um nichtflüchtig, d.h. auch nach dem Abschalten einer Versorgungsspannung, Ladung speichernde Speichereinheiten handelt. Bspw. ist der Speichertransistor ein sogenannter Split-Gate-Transistor, dessen Steuerbereich neben und über dem Ladungsspeicherbereich liegt.

Die Taschendotierbereiche werden auch als Pockets bezeichnet und grenzen bspw. an die Anschlussbereiche bzw. deren Erweiterung an. Die Taschendotierbereiche verhindern einen frühzeitigen Durchgriff bzw. punch through und werden bspw. symmetrisch an bzw. in der Nähe beider Anschlussbereiche ausgebildet.

Aus der US 5,912,488 ist eine Flash EEPROM Speicherzelle bekannt, deren Kanalbereich sich in einen sourceseitigen P+ Bereich und einen drainseitigen P- Bereich unterteilt, wobei beide Bereich unmittelbar aneinander grenzen. Die Speicherzelle wird gemäß dem CHE Verfahren (Channel Hot Elektron) selektiv programmiert, wobei Elektronen auf ein Floatinggate gelangen. Aus Oshima et al, "Process and device technologies for 16Mbit EPROMs with large-tilt-angle implanted p-pocket cell", IEDM 90, S. 95 bis 98, ist eine EPROM Speicherzelle bekannt, die zueinander symmetrische Taschendotierbereiche enthält. Die Speicherzelle wird wohl gemäß dem CHE Verfahren programmiert.

Es ist Aufgabe der Erfindung einen Speichertransistor anzugeben, der verbesserte elektronische Eigenschaften hat, und der insbesondere nur eine kleine Chipfläche benötigt. Außerdem sollen eine Speichereinheit mit einem solchen Speichertransistor, ein Betriebsverfahren und ein Herstellungsverfahren angegeben werden.

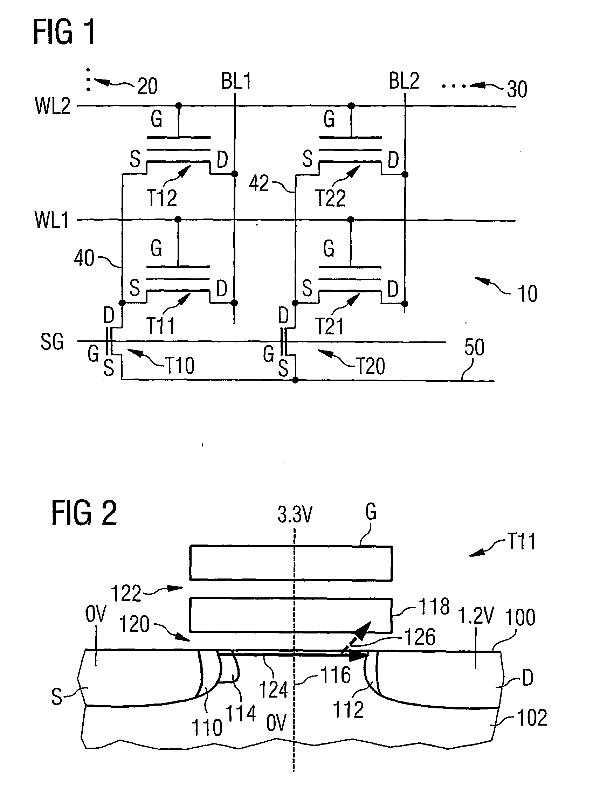

Die Erfindung geht von der Überlegung aus, dass einer Verkleinerung des Speichertransistors vorrangig Zuverlässigkeitsprobleme entgegenstehen. Wie unten an Hand der Figur 2 noch näher erläutert wird, kommt es insbesondere bei n-Kanal Speichertransistoren beim Lesen eines Speichertransistors bzw. einer Speicherzelle zu störenden Einprägungen von sogenannten heißen Elektronen in den Ladungsspeicherbereich. Die Elektronen sind in der Nähe des als Drain bzw. als Elektronensenke arbeitenden Anschlussbereiches am stärksten beschleunigt. Die Einprägung von bereits einem Elektron pro Tag kann über die geforderte mehrjährige Lebensdauer bzw. Ladungsspeicherzeit des Speichertransistors zu einer Änderung des Ladungszustandes des Speichertransistor führen, bspw. einer Änderung vom Zustand "Ladung nicht gespeichert" zum Zustand "Ladung gespeichert".

Die Erfindung ist im Patentanspruch 1 angegeben.

Um das Entstehen von heißen Elektronen zu verhindern, wird bei der erfindungsgemäßen Speicherzelle der Feldstärkegradient an der Drainseite betragsmäßig verringert, so dass auch das elektrische Feld geringer wird. Dies wird erreicht durch:
- einen näher zu dem Source-Anschlussbereich als zu dem Drain-Anschlussbereich angeordneten sourceseitigen Taschendotierbereich mit einem gleichen Dotiertyp wie der Kanalbereich aber mit einer vorzugsweise höheren Dotierstoffkonzentration als im Kanalbereich,
- durch einen asymmetrischen Aufbau des Speichertransistors hervorgerufen durch das Fehlen eines zweiten solchen Taschendotierbereiches näher an dem Drain-Anschlussbereich, wobei auch drainseitig eine Pocket verwendet, allerdings dotiert mit geringerer Dosis.
- und dadurch, dass der Source-Anschlussbereich in einer Lesebetriebsart des Speichertransistors als Elektronenquelle, d.h. als Source, für in den Kanalbereich transportierte Elektronen dient.

Die Verkleinerung der Abmessungen ist damit ohne sinkende Zuverlässigkeit der Speicherzelle möglich. Bei gleichbleibenden Abmessungen erhöht sich die Zuverlässigkeit.

Der sourceseitige Taschendotierbereich bzw. auch der drainseitige Taschendotierbereich hat bei einer Weiterbildung eine höhere Dotierstoffkonzentration als der Kanalbereich, um so einen punch through zwischen Source und Drain zu verhindern. Als Bezugspunkt beim Vergleich der Dotierstoffkonzentrationen dient bspw. die maximale Dotierstoffkonzentration in einem Bereich.

Bei einer Weiterbildung wird die Asymmetrie auch verursacht durch einen zum sourceseitigen Taschendotierbereich asymmetrischen drainseitigen Taschendotierbereich mit dem gleichen Dotiertyp wie der Kanalbereich aber mit einer anderen Dotierstoffkonzentration als der Kanalbereich, wobei die Asymmetrie durch mindestens eines der folgenden Merkmale entsteht:
- durch eine andere Form des drainseitigen Taschendotierbereiches im Vergleich zur Form des sourceseitigen Taschendotierbereiches,
- durch eine andere Lage des drainseitigen Taschendotierbereiches bezüglich des Drain-Anschlussbereiches im Vergleich zur Lage des sourceseitigen Taschendotierbereiches bezüglich des Source-Anschlussbereiches.

Bei einer Weiterbildung sind die Anschlussbereiche symmetrisch zueinander bezüglich einer Spiegelachse ausgebildet, die durch die Mitte des Steuerbereiches und durch die Mitte das Ladungsspeicherbereiches verläuft. Damit sind zusätzlich Maßnahmen zur Herstellung von Unsymmetrie von Anschlussbereichen bei der Herstellung des Speichertransistors nicht erforderlich.

Bei einer alternativen Weiterbildung sind die Anschlussbereiche asymmetrisch bezüglich der Spiegelachse ausgebildet. Durch die Asymmetrie ergeben sich verbesserte elektronische Eigenschaften des Speichertransistors bzw. einer Speichereinheit.

Bei einer Weiterbildung enthält ein Anschlussbereich jeweils einen Hauptanschlussbereich, der eine Dotierung eines anderen Dotiertyps wie der Kanalbereich hat. Ein Anschlussbereich oder beide Anschlussbereiche haben bei der Weiterbildung einen Erweiterungsbereich, der eine Dotierung des gleichen Dotiertyps wie der Hauptbereich jedoch mit einer geringeren Dotierstoffkonzentration als der Hauptbereich enthält. Die Funktion der Erweiterungsbereiche besteht darin, einen Anschluss der Anschlussbereiche in den von der Gatelektrode gesteuerten Kanalbereich herzustellen oder einen kleineren Feldgradienten beim Übergang von einem Anschlussgebiet zum Kanalgebiet zu erzeugen. Durch die asymmetrische Pocketimplantationen wird drainseitig ein geringerer Dotierstoffgradient erzeugt als sourceseitig. Dadurch herrscht drainseitig beim Lesen ein geringerer Feldgradient als bei symmetrischen Source-/Drain-Konstruktionen.

Die Erfindung betrifft außerdem eine Speichereinheit mit einer Vielzahl von erfindungsgemäßen Speichertransistoren bzw. deren Weiterbildungen. Bspw. sind mehrere Millionen Speichertransistoren in der Speichereinheit enthalten, so daß an die Zuverlässigkeit der Ladungsspeicherung besonders hohe Anforderungen gestellt werden.

Die Speichertransistoren sind bei einer Weiterbildung in der Speichereinheit matrixförmig angeordnet, wobei in einer Wortleitungsrichtung jeweils die Steuerbereiche von Speichertransistoren einer Zeile der Matrix über eine Wortleitung elektrisch leitfähig verbunden sind. In einer quer zur Wortleitungsrichtung liegenden Bitleitungsrichtung sind jeweils die Drain-Anschlussbereiche einer Spalte der Matrix über eine Bitleitung elektrisch leitfähig miteinander verbunden. Die Wortleitungen sind mit einem Wortleitungsdecoder elektrisch leitfähig verbunden oder verbindbar. Die Bitleitungen sind mit einem Bitleitungsdecoder und/oder mit einer Sensorschaltung elektrisch leitfähig verbunden oder verbindbar, die den Ladungszustand eines Ladungsspeicherbereiches erfasst. Die Sensorschaltung wird auch als Sense Amplifier bezeichnet.

Die Speichereinheit ist bspw. nach dem AND-Prinzip aufgebaut. Dies schließt aber nicht aus, daß die Speichereinheit bei einer alternativen Ausgestaltung gemäß dem NAND-Prinzip aufgebaut ist, bei dem die Anschlussbereiche verschiedener Speichertransistoren einer Spalte in Reihe geschaltet werden. Bei einer Alternative ist die Speichereinheit gemäß einer Architektur mit virtuellem Massepotential aufgebaut. Auch Architekturen mit Split-Gate-Zellen können erfindungsgemäße Speicherzellen enthalten.

Die Erfindung betrifft außerdem zum Betreiben des Speichertransistors ein Verfahren, gemäß dem der Speichertransistors mit einem Tunnelstrom programmiert wird, wobei abgesehen von Leckströmen kein Stromfluss zwischen Source und Drain auftritt.. Dagegen fließen bei einem sourceseitigen Einprägen von Ladungsträgern (source side injection) bzw. beim Programmieren mit sogenannten heißen bzw. schnellen Elektronen (Hot Channel Injection) zwischen Source und Drain Ströme größer 100 Nanoampere.

Bei einer nächsten Weiterbildung wird der Speichertransistor mit einem Tunnelstrom programmiert, der durch ein Grenzfläche zwischen dem Kanalbereich und einem Dielektrikum fließt, vorzugsweise mit gleicher Stromdichte in der gesamten Grenzfläche, ausgenommen die Gebiete, in denen das Feld durch den Taschendotierbereich beeinflusst wird. Dieses Verfahren wird auch als UCP (Uniform Channel Programming) bezeichnet. Insbesondere sind bei diesem Programmierverfahren keine starken Feldgradienten zum Erzeugen von schnellen Elektronen oder Feldspitzen an einem Anschlussbereich erforderlich, so dass der Taschendotierbereich beim Programmieren nicht stört. Bei einer Ausgestaltung wird auch mit Tunnelströmen gelöscht.

Bei einer nächsten Weiterbildung ist der Speichertransistor ein n-Kanal Transistor. Beim Lesen des Ladungszustands des Speichertransistors werden die folgenden Schritte ausgeführt:
- Anlegen eines Massepotentials an den Source-Anschlussbereich,
- Anlegen eines positiven Potentials an den Drain-Anschlussbereich,
- Anlegen eines positiven Potentials an den Steuer- bzw. Gatebereich, wobei das Gatepotential einen größeren Betrag als das positive Drainpotential hat.

Durch den asymmetrisch angeordneten Taschendotierbereich bzw. durch die zueinander asymmetrisch angeordneten Taschendotierbereiche wird bei dieser Lesebetriebsart erreicht, das die Elektronen im Kanalbereich nicht genug Energie haben, um die Energiebarriere zum Ladungsspeicherbereich zu überwinden. Deshalb kommt es auch zu keinen Störungen des in der Ladungsspeicherschicht gespeicherten Ladungszustandes durch Leseoperationen, d.h. zu keinem read-disturb.

Die Erfindung betrifft außerdem ein Verfahren zum Herstellen eines Speichertransistors mit asymmetrisch angeordnetem Taschendotierbereich. Der Taschendotierbereich wird durch eine Schrägimplantation erzeugt, wobei bei einer Weiterbildung der Drain-Anschlussbereich, in dessen Nähe ja kein oder ein Taschendotierbereich mit geringere Dotierstoffkonzentration ausgebildet werden soll, mit einer Maske vor dem Implantieren abgedeckt wird, bspw. mit einem Resist. Alternativ dient der Steuerbereich als Abschattung des Drainbereiches, wobei nur in einer Richtung schräg implantiert wird. Diese Alternative wird insbesondere z.B. bei einem klassischen AND-Loyout angewendet, bei dem es eine Schrägimplantationsrichtung für die Taschendotierbereiche gibt, bei der alle Drainbereiche des Speicherzellenfeldes abgeschattet.

Im folgenden wird die Erfindung an Hand der beiliegenden Figuren erläutert. Darin zeigen:
- Figur 1: einen Schaltplan eines Flash-Speicherzellenfeldes,
- Figur 2: die Potentialverhältnisse an einer Speicherzelle beim Lesen,
- Figur 3: einen Querschnitt in Bitleitungsrichtung durch das Speicherzellenfeld, und
- Figur 4: die Dotierstoffkonzentration zwischen Source und Drain in einer Speicherzelle.

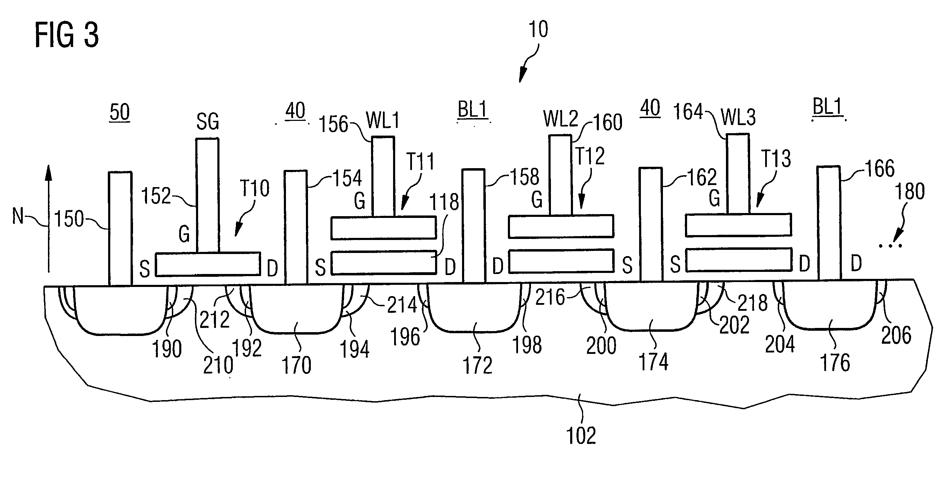

Figur 1 zeigt einen Schaltplan eines Flash-Speicherzellenfeldes 10, in dem eine Vielzahl von Speicherzellen matrixförmig in Zeilen und Spalten angeordnet sind. In Figur 1 sind vier Speicherzellen T11 bis T22 dargestellt, wobei der erste Index die Spalte und der zweite Index die Zeile angibt. Zum Beispiel liegt die Speicherzelle T12 in der ersten Spalte und in der zweiten Zeile. Die Speicherzellen T11 bis T22 sind untereinander gleich aufgebaut. Der Aufbau der Speicherzellen T11 und T13 wird unten an Hand der Figuren 2 und 3 näher erläutert.

Im Ausführungsbeispiel sind zwei Zeilen der Matrix dargestellt. Die Speicherzellen T11, T12 der ersten Zeile sind an ihren Gateelektroden durch eine in Zeilenrichtung liegende Wortleitung WL1 verbunden. Der Wortleitung WL1 ist eine Wortleitung WL2 benachbart, die ebenfalls in Zeilenrichtung verläuft und die u.a. die Gateelektroden der Speicherzellen T12 und T22 verbindet. Weitere Wortleitungen 20 sind durch Punkte angedeutet.

Im Ausführungsbeispiel sind außerdem zwei Spalten der Matrix dargestellt. Die Speicherzellen T11, T12 der ersten Spalte sind an ihren Drainelektroden D durch eine in Spaltenrichtung liegende lokale Bitleitung BL1 verbunden. Der lokalen Bitleitung BL1 ist eine lokale Bitleitung BL2 benachbart, die ebenfalls in Spaltenrichtung verläuft und die u.a. die Drainelektroden D der Speicherzellen T21 und T22 verbindet. Weitere lokale Bitleitungen 30 sind durch Punkte angedeutet. Die lokalen Bitleitungen BL1, BL2 erstrecken sich nur jeweils über einen Teilabschnitt einer Spalte der Matrix. Die lokalen Bitleitungen BL1, BL2 werden über nicht dargestellte Schalttransistoren mit globalen Bitleitungen verbunden, die sich jeweils über eine ganze Spalte der Matrix erstrecken und in Figur 1 aus Gründen der Übersichtlichkeit ebenfalls nicht dargestellt sind.

Die Sourceelektroden S der Speicherzellen einer Spalte sind durch lokale Sourceleitungen verbunden. So sind die Sourceelektroden S der Speicherzellen T11, T12 usw. durch eine lokale Sourceleitung 40 miteinander verbunden. Die Sourceelektroden S der Speicherzellen T21 und T22 der zweiten Spalte sind über eine lokale Sourceleitung 42 miteinander elektrisch leitfähig verbunden.

Die lokalen Sourceleitungen 40, 42 führen jeweils zum Drain D eines Schalttransistors T10, T20. Die Gates G der Schalttransistoren T10, T20 sind mit einer Steuerleitung SG verbunden. Die Sourceanschlüsse S der Schalttransistoren T10, T20 sind mit einer gemeinsamen Sourceleitung 50 verbunden, die Massepotential führt.

Bei der in Figur 1 gezeigten Speichereinheit 10 handelt es sich um eine Speichereinheit mit lokaler AND-Struktur. Jeweils bspw. acht oder sechzehn Zellen einer Spalte bilden eine AND-Struktur. Jedoch gibt es entlang einer globalen Bitleitung mehrere lokale Blöcke mit AND-Struktur.

Figur 2 zeigt mögliche Potentialverhältnisse an der Speicherzelle T11 beim Lesen an Hand eines Querschnitts durch die Speicherzelle T11. Die Speicherzelle T11 befindet sich auf einem Silizium Halbleitersubstrat 100 in einer schwach p-dotierten Wanne 102. Der Sourcebereich S und der Drainbereich D sind stark n-dotiert. Ein Sourceerweiterungsbereich 110 und ein Drainerweiterungsbereich 112 sind leicht n-dotiert. Nur an dem Sourceerweiterungsbereich 110 ist ein Taschendotierbereich 114 ausgebildet, der stärker p-dotiert ist, als die p-Wanne 102. Die Speicherzelle T11 ist abgesehen von dem Taschendotierbereich 114 spiegelsymmetrisch zu einer Spiegelachse 116 aufgebaut.

Zwischen dem Substrat 100 und einem elektrisch leitenden Floatinggate 118 befindet sich ein Tunneldielektrikum 120, das bspw. ein Dicke im Bereich von acht Nanometern bis zu zehn Nanometern hat. Zwischen dem Floatinggate 118 und dem Gate G befindet sich ein Dielektrikum 122.

Beim Lesen der Speicherzelle T11 liegen bspw. die folgenden Potentialverhältnisse vor:
- 0 Volt bzw. Massepotential an der Source S und an der Wanne 102,
- + 1,2 Volt am Drain D, und
- + 3,3 Volt am Gate.
Auf Grund dieser Potentialverhältnisse bildet sich an der Oberfläche des Substrats 102 zwischen Source S und Drain D ein Inversionskanal 124 aus, in dem Elektronen von der Source zum Drain hin beschleunigt werden. Auf Grund des Taschendotierbereiches 114 wird ein Durchgriff bzw. punch through verhindert. Das Fehlen eines Taschendotierbereiches am Drain D verhindert, dass die Elektronen zu stark beschleunigt werden. Während es bei bisher verwendeten Speicherzellen zu einer Einprägung einzelner Elektronen in das Floating Gate kommen konnte, wird dies bei der Speicherzelle T11 auf Grund des Fehlens eines Taschendotierbereiches zwischen der Symmetrie bzw. Spiegelachse 116 und dem Drain D verhindert. Die Speicherzelle T11 kann deshalb ihren Ladungszustand unverändert über 10 Jahre oder über 15 Jahre speichern, auch wenn täglich Leseoperationen ausgeführt werden.

Figur 3 zeigt beispielhaft einen Querschnitt in Bitleitungsrichtung durch den Schalttransistor T10, die Speicherzellen T11, T12 und durch eine Speicherzelle T13. Die lokale Bitleitung BL1, die lokale Sourceleitung 40, die Steuerleitung SG und die gemeinsame Sourceleitung 50 sind bspw. in nicht dargestellten Metallisierungslagen ausgeführt. Die Wortleitungen WL1, WL2 und eine Wortleitung WL sind bspw. aus hochdotiertem polykristallinem Silizium hergestellt worden.

Folgende Kontakte dienen zum Anschluss der Transistoren T10 bis T13:
- ein mit der gemeinsamen Sourceleitung 50 verbundener Kontakt 150 führt zum Sourcebereich S des Schalttransistors T10,
- ein mit der Steuerleitung SG verbundener Kontakt 152 führt zum Gate G des Schalttransistors T10,
- ein mit der lokalen Sourceleitung 40 verbundener Kontakt 154 führt zu einem n-Dotierbereich 170, der das Drain D des Schalttransistors T10 und die Source S des Speichertransistors der Speicherzelle T11 bildet,
- ein Kontakt 156 liegt zwischen der Wortleitung WL1 und dem Gate G der Speicherzelle T11,
- ein Kontakt 158 liegt zwischen der lokalen Bitleitung BL1 und einem n-dotierten Dotierbereich 172, der die Drainbereiche D der Speicherzellen T11 und T12 bildet,
- ein Kontakt 160 liegt zwischen der Wortleitung WL2 und dem Gate G der Speicherzelle T12,
- ein mit der lokalen Sourceleitung 40 verbundener Kontakt 162 führt zu einem n-Dotierbereich 174, der die Source S des Speichertransistors der Speicherzelle T12 und die Source S des Speichertransistors der Speicherzelle T13 bildet,
- ein Kontakt 164 liegt zwischen der Wortleitung WL3 und dem Gate G der Speicherzelle T13,
- ein Kontakt 166 liegt zwischen der lokalen Bitleitung BL1 und einem n-dotierten Dotierbereich 176, der die Drainbereiche D der Speicherzellen T13 und T14 bildet,
- weitere Kontakte 180, die abwechselnd zum Anschließen einer Wortleitung WLx, der Sourceleitung 40, einer Wortleitung WLx+1, der Bitleitung BL1, usw. dienen.

An der Source S des Schalttransistors T10 ist eine schwach n-dotierter Erweiterungsbereich 190 ausgebildet. An den Diffusionsbereichen 170 bis 176 sind jeweils zu den beiden angrenzenden Kanalbereichen hin zwei im Vergleich zu diesen Diffusionsbereichen schwach n-dotierte Erweiterungsbereiche 192, 194; 196, 198; 200, 202 bzw. 204 und 206 ausgebildet.

An den Erweiterungsbereichen 190, 192 des Schalttransistors T10 befindet sich jeweils ein Taschendotierbereich 210 bzw. 212 mit entgegengesetztem Dotiertyp im Vergleich zu den Erweiterungsbereichen 190, 192 und mit dem gleichen Dotiertyp wie der Kanalbereich bzw. die p-Wanne 102. Jedoch sind die Taschendotierbereiche 210, 212 höher als die p-Wanne 102 dotiert. Jeweils nur an den sourceseitigen Erweiterungsbereichen 194, 200, 202 usw. der Speicherzellen T11 bis T13 befinden sich Taschendotierbereiche 216 bis 218 vom gleichen Dotiertyp und mit der gleichen Dotierstoffkonzentration wie die Taschendotierbereiche 210 und 212. An den drainseitigen Erweiterungsbereichen 196, 198, 204, 206 usw. befinden sich dagegen keine Taschendotierbereiche. Bezüglich der Speicherzelle T11 ist in Figur 3 ein von Figur 2 abweichendes Dotierprofil gezeigt. Beide Dotierprofile erfüllen aber die oben an Hand der Figur 2 erläuterte Funktion der Unterdrückung von Fehlern.

Die Dotierbereiche 170, 172 und 174 sowie die Erweiterungsbereiche 190 bis 206 sind mit einer genau entgegen der Normalenrichtung N des Substrates 100 gerichteten Implantation erzeugt worden. Die Taschendotierbereiche 210 bis 218 sind dagegen mit einer Schrägimplantation erzeugt worden, deren Implantationsrichtung um einem Winkel größer als 10 Grad vom Winkel der senkrechten Implantation abweicht.

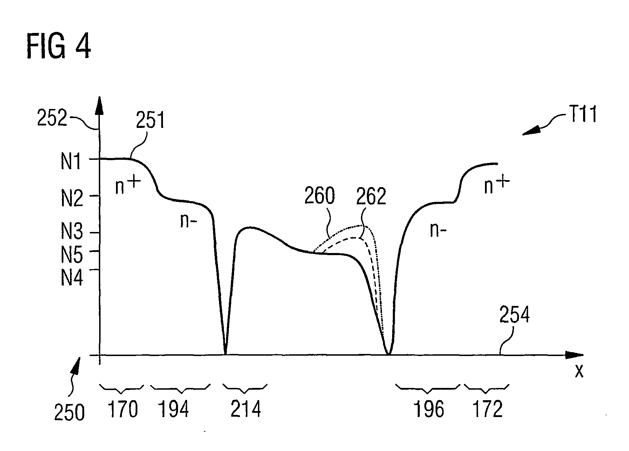

Figur 4 zeigt schematisch in einem Diagramm 250 eine Kurve 251 des Betrages der auf einer y-Achse logarithmisch abgetragenen Nettodotierstoffkonzentration abhängig von einer auf einer x-Achse 254 abgetragenen Position in Bitleitungsrichtung. Die Nettodotierstoffkonzentration ergibt sich aus der Differenz der Dotierstoffatome, die zum n-Leitungstyp führen, und der Dotierstoffatome, die zum p-Leitungstyp führen. Die Nettodotierstoffkonzentration ist auf der y-Achse 252 im Bereich von bspw. 10¹⁵ Dotierstoffatome je Kubikzentimeter bis bspw. 10²² Dotierstoffatome je cm³ abgetragen. Der Anfang der x-Achse 254 gibt bspw. die Position der Source S der Speicherzelle T11 im Substrat 100 an. Der dargestellte Teil der x-Achse 254 endet am Drain D der Speicherzelle T11.

Die Kurve 251 hat beginnend von der Source S bis zum Drain D in der angegebenen Reihenfolge den folgenden kontinuierlichen Verlauf:
- eine hohe Nettodotierstoffkonzentration N1 im Dotierbereich 170, auf Grund eines starken Übergewichtes von bspw. Arsen- oder Phosphordotieratomen. Die Dotierstoffkonzentration N1 liegt bspw. im Bereich von 10²⁰ bis 10²² Dotierstoffatome je Kubikzentimeter, im Ausführungsbeispiel bei 5 10²⁰ Dotierstoffatome je Kubikzentimeter.
- eine um mindestens eine Zehnerpotenz geringere Nettodotierstoffkonzentration N2 im Erweiterungsbereich 194. Die Dotierstoffkonzentration N2 liegt im Ausführungsbeispiel bei 5 10¹⁹ Dotierstoffatome je Kubikzentimeter.
- eine Nettodotierstoffkonzentration nahe 10¹⁵ Dotierstoffatome je Kubikzentimeter am Übergang zwischen dem Erweiterungsbereich 194 und dem Taschendotierbereich 214,
- ein lokales Maximum einer Nettodotierstoffkonzentration N3 etwa in der Mitte des Taschendotierbereiches 214, auf Grund eines Übergewichtes von bspw. Bordotieratomen. Im Ausführungsbeispiel beträgt N3 bspw. 5 10¹⁸ Dotierstoffatome je Kubikzentimeter. N3 liegt allgemein mindestens um eine Zehnerpotenz über der Dotierstoffkonzentration im Kanal.
- einen schwach fallenden Abschnitt vom Wert N3 bis zu einer Dotierstoffkonzentration N4 von bspw. 5 10¹⁷ Dotierstoffatome je Kubikzentimeter,
- einen stark fallenden Abschnitt vom Wert N4 bis zum Wert von 10¹⁵ Dotierstoffatome je Kubikzentimeter an der Grenze von Kanalbereich und Erweiterungsbereich 196,
- einen steigenden Abschnitt bis auf den Wert N2 im Erweiterungsbereich 196,
- den Wert N1 im Drain-Dotierbereich 172.

Der Abstand zwischen den beiden Minima und damit die Kanallänge einschließlich der Länge des Taschendotierbereiches beträgt im Ausführungsbeispiel 120 Nanometer. Bei anderen Ausführungsbeispielen ist der Abstand auch kleiner als 120 Nanometer.

An dem Taschendotierbereich 214 ergibt sich ein "harter" n/p-Übergang mit starkem Nettodotierstoffkonzentrationsanstieg.

Dagegen führt das Fehlen bzw. die reduzierte Dotierung eines Taschendotierbereiches am Erweiterungsbereiches 196 zu einem "weicheren" p/n-Übergang mit einem geringeren Nettodotierstoffkonzentrationsabfall und Nettodotierstoffkonzentrationsanstieg. Der Anstieg der Kurve 251 in ihrem drainseitigen lokalen Minimum ist ein Maß für die dort existierende Feldstärke. Im Minimum am Erweiterungsbereich 196 sind die Anstiege bzw. ersten Ableitungen der Kurve 251 betragsmäßig klein, was mit einer verringerten Feldstärke verbunden ist.

Die verringerte Feldstärke nahe des Erweiterungsbereiches 196 führt zu einer geringeren Beschleunigung von bereits im Kanalbereich vorbeschleunigten Elektronen im Vergleich zu einem durch ein gestrichelte Linie angedeuteten Kurvenverlauf 260 mit zwei zueinander symmetrischen Taschendotierbereichen. Die verringerte Beschleunigung führt zu einer kleineren Geschwindigkeit der Elektronen am Ende des Kanalbereiches. Auf Grund der kleineren Geschwindigkeit werden störende Einprägungen von Elektronen in das Floatinggate 118 während des Lesens der Speicherzelle T11 vermieden.

Erfindungsgemäß wird zusätzlich zu dem sourceseitigen Taschendotierbereich 114 bzw. 214 ein drainseitiger Taschendotierbereich 262 verwendet, dessen maximale Dotierstoffkonzentration N5 zwischen der Dotierstoffkonzentration N3 und N4 liegt, bspw. in der Hälfte zwischen N3 und N4, d.h. für die oben genannten Werte bei 1 10¹⁸ Dotierstoffatome je Kubikzentimeter. Auch in diesem Fall ergibt sich eine Unterdrückung von Fehlprogrammierungen während des Lesens. Zusätzlich wird jedoch die punch-through-Spannung weiter erhöht.

Beispielsweise werden Grunddotierungen für den drainseitigen Taschendotierbereich 262 und für den sourceseitigen Taschendotierbereich 214 mit der gleichen Lithografie, insbesondere mit derselben Fotomaske, wie die Erweiterungsbereiche 110 und 112 bzw. 190 und 192 erzeugt. Anschließend oder vorher wird mit einer zusätzlichen Maske der Drainbereich bzw. der für den Drainbereich vorgesehene Bereich abgedeckt, um die Dotierstoffkonzentration in dem sourceseitigen Taschendotierbereich mit Hilfe einer weiteren Schrägimplantation zu erhöhen.

Bei anderen Ausführungsbeispielen enthält eine Speicherzelle jeweils mehr als einen Transistor, bspw. einen Speichertransistor und einen Ansteuertransistor.

Obwohl Ausführungsbeispiele für n-Kanaltransistoren erläutert worden sind, gelten die technischen Wirkunken auch für p-Kanaltransistoren. Bei p-Kanaltransistoren werden die Löcher auf Grund der asymmetrischen Pockets beim Lesen weniger stark beschleunigt, so dass Schädigungen bspw. eines am Kanalbereich angrenzenden Oxids vermieden werden. Damit tritt eine geringere Degradation des Floating-Gatedielektrikums auf. Bei p-Kanaltransistoren sind die Potentialverhältnisse und die Dotiertypen umgekehrt zu den angegebenen Potentialverhältnissen und Dotiertypen zu wählen.

## Patentansprüche

1. Integrierter Speichertransistor (T11),
mit einem Drain-Anschlussbereichen (D) und einem Source-Anschlussbereich (S), der in einer Lesebetriebsart des Speichertransistors (T11) als Elektronenquelle für in den Kanalbereich (102) transportierte Elektronen dient,
mit einem zwischen den Anschlussbereichen (S, D) angeordneten Kanalbereich (102),
mit einem Steuerbereich (G),
mit einem zwischen dem Steuerbereich (G) und dem Kanalbereich (102) angeordneten Ladungsspeicherbereich (118),
mit einem näher zu dem Source-Anschlussbereich (S) als zu dem Drain-Anschlussbereich (D) angeordneten sourceseitigen Taschendotierbereich (114) mit einem gleichen Dotiertyp wie der Kanalbereich (102) aber mit einer anderen Dotierstoffkonzentration als im Kanalbereich (102),
wobei Taschendotierbereiche (114, 262) eine höhere Dotierstoffkonzentration als der Kanalbereich (102) haben, **gekennzeichnet durch** einen asymmetrischen Aufbau verursacht durch das Fehlen eines zum sourceseitigen Taschendotierbereich (114) symmetrischen drainseitigen Taschendotierbereiches, der näher zu dem Drain-Anschlussbereich (D) als zu dem Source-Anschlussbereich (S) angeordnet ist,
wobei die Asymmetrie verursacht wird **durch** einen zum sourceseitigen Taschendotierbereich (114) asymmetrischen drainseitigen Taschendotierbereich (262) mit dem gleichen Dotiertyp wie der Kanalbereich (102) aber mit einer anderen Dotierstoffkonzentration als der Kanalbereich (102) und **durch** eine andere Dotierstoffkonzentration im drainseitigen Taschendotierbereich (262) im Vergleich zur Dotierstoffkonzentration im sourceseitigen Taschendotierbereich (114).

2. Speichertransistor (T11) nach Anspruch 1, **dadurch gekennzeichnet, dass** die Asymmetrie verursacht wird durch den zum sourceseitigen Taschendotierbereich (114) asymmetrischen drainseitigen Taschendotierbereich (262) mit dem gleichen Dotiertyp wie der Kanalbereich (102) aber mit einer anderen Dotierstoffkonzentration als der Kanalbereich (102), wobei die Asymmetrie auch durch eine andere Form des drainseitigen Taschendotierbereiches (262) im Vergleich zur Form des sourceseitigen Taschendotierbereiches (114) entsteht.

3. Speichertransistor (T11) nach Anspruch 1 oder 2, **dadurch gekennzeichnet, dass** die Asymmetrie verursacht wird durch den zum sourceseitigen Taschendotierbereich (114) asymmetrischen drainseitigen Taschendotierbereich (262) mit dem gleichen Dotiertyp wie der Kanalbereich (102) aber mit einer anderen Dotierstoffkonzentration als der Kanalbereich (102), wobei die Asymmetrie auch durch eine andere Lage des drainseitigen Taschendotierbereiches (262) bezüglich des Drain-Anschlussbereiches (D) im Vergleich zur Lage des sourceseitigen Taschendotierbereiches (114) bezüglich des Source-Anschlussbereiches (S) entsteht.

4. Speichertransistor (T11) nach einem der vorhergehenden Ansprüche, **dadurch gekennzeichnet, dass** die Anschlussbereiche (S, D) symmetrisch zueinander bezüglich einer Spiegelachse (116) ausgebildet sind, die durch die Mitte des Steuerbereiches (G) und durch die Mitte das Ladungsspeicherbereiches (118) verläuft,
oder dass die Anschlussbereiche (S, D) asymmetrisch bezüglich der Spiegelachse ausgebildet sind.

5. Speichertransistor (T11) nach einem der Ansprüche 1 bis 3, **dadurch gekennzeichnet, dass** ein Anschlussbereich (S, D) einen Hauptanschlussbereich enthält, der eine Dotierung eines anderen Dotiertyps wie der Kanalbereich (102) hat,
und dass vorzugsweise nur ein Anschlussbereich (S, D) oder beide Anschlussbereiche (S, D) einen Erweiterungsbereich (112, 114) enthalten, der eine Dotierung des gleichen Dotiertyps wie der Hauptbereich jedoch mit einer geringeren Dotierstoffkonzentration als der Hauptbereich enthält.

6. Speichertransistor (T11) nach einem der vorhergehenden Ansprüche, **dadurch gekennzeichnet, dass** der sourceseitige Taschendotierbereich (114) eine höhere Dotierstoffkonzentration als der drainseitge Taschendotierbereich (262) hat, wobei vorzugsweise die Nettodotierstoffkonzentration betrachtet wird.

7. Speichereinheit (10) **gekennzeichnet durch** eine Vielzahl von Speichertransistoren (T11 bis T22) nach einem der vorhergehenden Ansprüche.

8. Speichereinheit (10) nach Anspruch 7, **dadurch ge-kennzeichnet, dass** die Speichertransistoren (T11 bis T22) matrixförmig angeordnet sind,
wobei in einer Wortleitungsrichtung jeweils die Steuerbereiche (G) von Speichertransistoren einer Zeile der Matrix über eine Wortleitung (WL1 bis WL3) elektrisch leitfähig verbunden sind,
und wobei in einer quer zur Wortleitungsrichtung liegenden Bitleitungsrichtung jeweils die Drain-Anschlussbereiche (D) einer Spalte der Matrix über eine Bitleitung (BL1, BL2) elektrisch leitfähig miteinander verbunden sind.

9. Speichereinheit (10) nach Anspruch 8, **dadurch gekennzeichnet, dass** die Wortleitungen (WL1, WL2) mit einem Wortleitungsdecoder elektrisch leitfähig verbunden oder verbindbar sind,
und dass die Bitleitungen (BL1, BL2) mit einem Bitleitungsdecoder und/oder mit einer Sensorschaltung elektrisch leitfähig verbunden oder verbindbar sind, die den Ladungszustand eines Ladungsspeicherbereiches (118) erfasst.

10. Speichereinheit (10) nach Anspruch 8 oder 9, **dadurch gekennzeichnet, dass** jeweils die Source-Anschlussbereiche (S) einer Spalte der Matrix über eine Sourceleitung (40, 42) elektrisch leitfähig miteinander verbunden sind, die nur an Anschlussbereiche (S) von Speichertransistoren einer Spalte der Matrix angeschlossen ist.

11. Verfahren zum Betreiben eines Speichertransistors (T11) nach einem der Ansprüche 1 bis 6 oder zum Betreiben einer Speichereinheit (10) nach einem der Ansprüche 7 bis 10, **gekennzeichnet durch** den folgenden Schritt: Programmieren des Speichertransistors (T11) mit einem Tunnelstrom, wobei der Stromfluss in einem Kanalbereich (124) beim Programmieren vorzugsweise kleiner als ein Nanoampere ist.

12. Verfahren nach Anspruch 11, **gekennzeichnet durch** den folgenden Schritt:
Programmieren des Speichertransistors (T11) mit einem Tunnelstrom, der **durch** eine Grenzfläche zwischen dem Kanalbereich (124) und einem Dielektrikum (126) fließt, vorzugsweise mit gleicher Stromdichte in der gesamten Grenzfläche.

13. Verfahren nach Anspruch 11 oder 12, **gekennzeichnet durch** die folgenden Schritte beim Lesen des Ladungszustands eines n-Kanal Speichertransistors:
Anlegen eines Massepotentials oder eines positiven Potentials an den Source-Anschlussbereich (S),
Anlegen eines im Vergleich zum Potential an dem Source-Anschlussbereich (S) positiveren Potentials an den Drain-Anschlussbereich (D),
und vorzugsweise Anlegen eines positiven Potentials an den Steuerbereich (G), wobei dieses Potential positiver als das Potential am Source-Anschlussbereich (S) ist,
oder **durch** die folgenden Schritte beim Lesen des Ladungszustands eines p-Kanal Speichertransistors:
Anlegen eines Massepotentials oder eines negativen Potentials an den Source-Anschlussbereich (S),
Anlegen eines im Vergleich zum Potential an dem Source-Anschlussbereich (S) negativeren Potentials an den Drain-Anschlussbereich (D),
und vorzugsweise Anlegen eines negativen Potentials an den Steuerbereich (G), wobei dieses Potential negativer als das Potential am Source-Anschlussbereich (S) ist.

14. Verfahren zum Herstellen eines Speichertransistors (T11) nach einem der Ansprüche 1 bis 6 oder zum Herstellen einer Speichereinheit (10) nach einem der Ansprüche 7 bis 10, **gekennzeichnet durch** den folgenden Schritt: Erzeugen des Taschendotierbereiches (114, 262) **durch** eine Schrägimplantation.

15. Verfahren nach Anspruch 14, **gekennzeichnet durch** den folgenden Schritt:
Abdecken des Drain-Anschlussbereiches (D) mit einer Maske vor dem Implantieren oder Abschatten des Drain-Anschlussbereiches (D) **durch** den Gatestapel beim Implantieren.

## Claims

1. Integrated memory transistor (T11),
having a drain terminal region (D) and a source terminal region (S), which, in a read operating mode of the memory transistor (T11), serves as an electron source for electrons transported into the channel region (102),
having a channel region (102) arranged between the terminal regions (S, D),
having a control region (G),
having a charge storage region (118) arranged between the control region (G) and the channel region (102),
having a source-side pocket doping region (114) arranged nearer to the source terminal region (S) than to the drain terminal region (D) and having an identical doping type to the channel region (102) but having a different dopant concentration than in the channel region (102),
the pocket doping regions (114, 262) having a higher dopant concentration than the channel region (102), **characterized by** an asymmetrical construction caused by the absence of a drain-side pocket doping region that is symmetrical with respect to the source-side pocket doping region (114) and is arranged nearer to the drain terminal region (D) than to the source terminal region (S),
wherein the asymmetry is caused by a drain-side pocket doping region (262) that is asymmetric with respect to the source-side pocket doping region (114) and has the same doping type as the channel region (102) but has a different dopant concentration than the channel region (102) and by a different dopant concentration in the drain-side pocket doping region (262) in comparison with the dopant concentration in the source-side pocket doping region (114).

2. Memory transistor (T11) according to Claim 1, **characterized in that** the asymmetry is caused by the drain-side pocket doping region (262) that is asymmetric with respect to the source-side pocket doping region (114) and has the same doping type as the channel region (102) but has a different dopant concentration than the channel region (102), the asymmetry also arising by virtue of a different form of the drain-side pocket doping region (262) in comparison with the form of the source-side pocket doping region (114).

3. Memory transistor (T11) according to Claim 1 or 2, **characterized in that** the asymmetry is caused by the drain-side pocket doping region (262) that is asymmetric with respect to the source-side pocket doping region (114) and has the same doping type as the channel region (102) but has a different dopant concentration than the channel region (102), the asymmetry also arising by virtue of a different position of the drain-side pocket doping region (262) with respect to the drain terminal region (D) in comparison with the position of the source-side pocket doping region (114) with respect to the source terminal region (S).

4. Memory transistor (T11) according to one of the preceding claims, **characterized in that** the terminal regions (S, D) are formed symmetrically with respect to one another in relation to a mirror axis (116) running through the center of the control region (G) and through the center of the charge storage region (118), or **in that** the terminal regions (S, D) are formed asymmetrically in relation to the mirror axis.

5. Memory transistor (T11) according to one of Claims 1 to 3, **characterized in that** a terminal region (S, D) contains a main terminal region having a doping of a different doping type to the channel region (102), and **in that** preferably only one terminal region (S, D) or both terminal regions (S, D) contain an extension region (112, 114) containing a doping of the same doping type as the main region but with a lower dopant concentration than the main region.

6. Memory transistor (T11) according to one of the preceding claims, **characterized in that** the source-side pocket doping region (114) has a higher dopant concentration than the drain-side pocket doping region (262), preferably the net dopant concentration being considered.

7. Memory unit (10) **characterized by** a multiplicity of memory transistors (T11 to T22) according to one of the preceding claims.

8. Memory unit (10) according to Claim 7, **characterized in that** the memory transistors (T11 to T22) are arranged in matrix form,
in a word line direction the control regions (G) of memory transistors of a row of the matrix in each case being electrically conductively connected via a word line (WL1 to WL3),
and in a bit line direction situated transversely with respect to the word line direction the drain terminal regions (D) of a column of the matrix in each case being electrically conductively connected to one another via a bit line (BL1, BL2).

9. Memory unit (10) according to Claim 8,
**characterized in that** the word lines (WL1, WL2) are electrically conductively connected or connectable to a word line decoder,
and **in that** the bit lines (BL1, BL2) are electrically conductively connected or connectable to a bit line decoder and/or to a sensor circuit which detects the charge state of a charge storage region (118).

10. Memory unit (10) according to Claim 8 or 9, **characterized in that** the source terminal regions (S) of a column of the matrix are in each case electrically conductively connected to one another via a source line (40, 42) which is only connected to terminal regions (S) of memory transistors of a column of the matrix.

11. Method for operating a memory transistor (T11) according to one of Claims 1 to 6 or for operating a memory unit (10) according to one of Claims 7 to 10, **characterized by** the following step:
programming of the memory transistor (T11) with a tunnelling current, the current flow in a channel region (124) during programming preferably being less than one nanoampere.

12. Method according to Claim 11, **characterized by** the following step:
programming of the memory transistor (T11) with a tunnelling current that flows through an interface between the channel region (124) and a dielectric (126), preferably with the same current density in the entire interface.

13. Method according to Claim 11 or 12, **characterized by** the following steps when reading the charge state of an n-channel memory transistor:
application of a ground potential or of a positive potential to the source terminal region (S),
application to the drain terminal region (D) of a potential that is more positive in comparison with the potential at the source terminal region (S),
and preferably application of a positive potential to the control region (G), said potential being more positive than the potential at the source terminal region (S),
or the following steps when reading the charge state of a p-channel memory transistor:
application of a ground potential or of a negative potential to the source terminal region (S),
application to the drain terminal region (D) of a potential that is more negative in comparison with the potential at the source terminal region (S),
and preferably application of a negative potential to the control region (G), said potential being more negative than the potential at the source terminal region (S).

14. Method for fabricating a memory transistor (T11) according to one of Claims 1 to 6 or for fabricating a memory unit (10) according to one of Claims 7 to 10, **characterized by** the following step:
production of the pocket doping region (114, 262) by an inclined implantation.

15. Method according to Claim 14, **characterized by** the following step:
covering of the drain terminal region (D) with a mask prior to the implantation or shading of the drain terminal region (D) by the gate stack during the implantation.

## Revendications

1. Transistor (T11) de mémoire intégré
comprenant une zone (D) de borne de drain et une zone (S) de borne de source qui, dans un type de fonctionnement en lecture du transistor (T11) de mémoire, sert de source d'électrons pour des électrons transportés dans la zone (102) de canal ;
comprenant une zone (102) de canal, disposée entre les zones (S, D) de borne ;
comprenant une zone (G) de commande ;
comprenant une zone (118) d'emmagasinage de charge, disposée entre la zone (G) de commande et la zone (102) de canal ;
comprenant une zone (114) dopée à poche du côté source, disposée plus près de la zone (S) de borne de source que de la zone (D) de borne de drain et ayant un type de dopage identique à celui de la zone (102) de canal, mais avec une concentration de substance de dopage autre que dans la zone (102) de canal ;
dans lequel des zones (114, 262) de dopage à poche ont une concentration de substance de dopage plus grande que la zone (102) de canal ;
**caractérisé par** une structure dissymétrique provoquée par l'absence d'une zone de dopage à poche du côté drain, qui est symétrique de la zone (114) de dopage à poche du côté source et qui est disposée plus près de la zone (D) de borne de drain que de la zone (S) de borne de source ;
dans lequel la dissymétrie est provoquée par une zone (262) de dopage à poche du côté drain, dissymétrique de la zone (114) de dopage à poche du côté source et ayant le même type de dopage que la zone (102) de canal, mais avec une concentration de substance de dopage autre que la zone (102) de canal et par une concentration de substance de dopage de la zone (262) de dopage à poche du côté drain autre que la concentration de substance de dopage de la zone (114) de dopage à poche du côté source.

2. Transistor (T11) de mémoire suivant la revendication 1, **caractérisé en ce que** la dissymétrie est provoquée par la zone (262) de dopage à poche du côté drain, dissymétrique de la zone (114) de dopage à poche du côté, source et ayant le même type de dopage que la zone (102) de canal, mais ayant une concentration de substance de dopage autre que la zone (102) de canal, la dissymétrie provenant aussi d'une forme de la zone (262) de dopage à poche du côté drain autre que la forme de la zone (114) de dopage à poche du côté source.

3. Transistor (T11) de mémoire suivant la revendication 1 ou 2, **caractérisé en ce que** la dissymétrie est provoquée par la zone (262) de dopage à poche du côté drain, dissymétrique de la zone (114) de dopage à poche du côté source et ayant le même type de dopage que la zone (102) de canal, mais une concentration de substance de dopage autre que la zone (102) de canal, la dissymétrie étant produite aussi par une position de la zone (262) de dopage à poche du côté drain, par rapport à la zone (D) de borne de drain, autre que la position de la zone (114) de dopage à poche du côté source, par rapport à la zone (S) de borne de source.

4. Transistor (T11) de mémoire suivant l'une des revendications précédentes, **caractérisé en ce que** les zones (S, D) de borne sont symétriques l'une de l'autre par rapport à un axe (116) comme en un miroir, qui passe par le milieu de la zone (G) de commande et par le milieu de la zone (118) d'accumulation de charge ;
ou **en ce que** les zones (S, D) de borne sont dissymétriques par rapport à l'axe comme en un miroir.

5. Transistor (T11) de mémoire suivant l'une des revendications 1 à 3, **caractérisé en ce que** la zone (S, D) de borne comporte une zone de borne principale, qui a un dopage d'un autre type de dopage que la zone (102) de canal ;
et **en ce que**, de préférence, seulement une zone (S, D) de borne ou les deux zones (S, D) de borne comportent une zone (112, 114) d'élargissement, qui comporte un dopage du même type de dopage que la zone principale, mais ayant une concentration de substance de dopage plus petite que la zone principale.

6. Transistor (T11) de mémoire suivant l'une des revendications précédentes, **caractérisé en ce que** la zone (114) de dopage à poche du côté source a une concentration de substance de dopage plus grande que la zone (262) de dopage à poche du côté drain, en considérant de préférence la concentration nette de substance de dopage.

7. Unité (10) de mémoire, **caractérisée par** une pluralité de transistors (T11 à T22) de mémoire suivant l'une des revendications précédentes.

8. Unité (10) de mémoire suivant la revendication 7, **caractérisée en ce que** les transistors (T11 à T22) de mémoire sont disposés sous la forme d'une matrice ;
dans laquelle, dans une direction de ligne de mots, respectivement les zones (G) de commande de transistor de commande d'une ligne de la matrice sont reliées d'une manière conductrice de l'électricité par une ligne (WL1, WL2) de mots,
et dans laquelle, dans une direction de ligne de bits, transversalement à la direction de la ligne de mots, respectivement les zones (D) de borne de drain d'une colonne de la matrice sont reliées entre elles d'une manière conductrice de l'électricité par une ligne (BL1, BL2) de bits.

9. Unité (10) de mémoire suivant la revendication 8, **caractérisée en ce que** les lignes (WL1, WL2) de mots sont reliées ou peuvent être reliées d'une manière conductrice de l'électricité à un décodeur de lignes de mots ;
et **en ce que** les lignes (BL1, BL2) de bits sont reliées ou peuvent être reliées d'une manière conductrice de l'électricité à un décodeur de lignes de bits et/ou à un circuit de capteurs, qui détecte l'état de charge d'une zone (118) d'emmagasinage de charge.

10. Unité (10) de mémoire suivant la revendication 8 ou 9, **caractérisée en ce que**, respectivement, les zones (S) de borne de source, d'une colonne de la matrice sont reliées entre elles d'une manière conductrice de l'électricité par une ligne (40, 42) de source, qui n'est raccordée qu'aux zones (S) de borne de transistors de mémoire d'une colonne de la matrice.

11. Procédé pour faire fonctionner un transistor (T11) de mémoire suivant l'une des revendications 1 à 6 ou pour faire fonctionner une unité (10) de mémoire suivant l'une des revendications 7 à 10, **caractérisé par** les stades suivants :
on programme le transistor (T11) de mémoire par un courant de tunnel, l'intensité du courant dans une zone (124) de canal lors de la programmation étant, de préférence, plus petite qu'un nanoampère.

12. Procédé suivant la revendication 11, **caractérisé par** le stade suivant :
on programme le transistor (T11) de mémoire par un courant de tunnel, qui passe dans une interface entre la zone (124) de canal et un diélectrique (126) en ayant de préférence la même densité de courant dans toute l'interface.

13. Procédé suivant la revendication 11 ou 12, **caractérisé par** les stades suivants lors de la lecture de l'état de charge d'un transistor de mémoire à canal n :
on applique un potentiel de masse ou un potentiel positif à la zone (S) de borne de source ;
on applique à la zone (D) de borne de drain un potentiel plus positif que le potentiel appliqué à la zone (S) de borne de source ;
et, de préférence, on applique un potentiel positif à la zone (G) de commande, ce potentiel étant plus positif que le potentiel appliqué à la zone (S) de borne de source ;
ou, par les stades suivants, lors de la lecture de l'état de charge d'un transistor de mémoire à canal p :
on applique un potentiel de masse ou un potentiel négatif à la zone (S) de borne de source ;
on applique à la zone (D) de borne de drain un potentiel plus négatif que le potentiel appliqué à la zone (S) de borne de source ;
et, de préférence, on applique un potentiel négatif à la zone (G) de commande, ce potentiel étant plus négatif que le potentiel appliqué à la zone (S) de borne de source.

14. Procédé de production d'un transistor (T11) de mémoire suivant l'une des revendications 1 à 6 ou de production d'une unité (10) de mémoire suivant l'une des revendications 7 à 10, **caractérisé par** le stade suivant : on produit la zone (114, 262) de dopage à poche par une implantation inclinée.

15. Procédé suivant la revendication 14, **caractérisé par** le stade suivant :
on recouvre la zone (D) de borne de drain d'un masque avant l'implantation ou l'on masque la zone (D) de borne de drain par la pile de grilles lors de l'implantation.
